# EUROPEAN PATENT SPECIFICATION

(11) **EP 3 316 298 B1**
(45) Date of publication and mention of the grant of the patent: **11.08.2021**
(21) Application number: 17187540.4
(22) Date of filing: 23.08.2017
(51) Int. Cl.: H01L 25/075, H01L 33/50, H01L 33/60

(54) **COB LIGHT SOURCE**
COB-LICHTQUELLE
SOURCE DE LUMIÈRE COB

(30) Priority: 31.10.2016 CN 201610928056
(43) Date of publication of application: 02.05.2018
(73) Proprietor: Foshan Evercore Optoelectronic Technology Co.,Ltd., Foshan City Guangdong Province (CN)
(72) Inventor: WANG, Mengyuan, Foshan City (CN); ZHU, Siyuan, Foshan City (CN); ZENG, Weiqiang, Foshan City (CN)
(74) Representative: Sun, Yiming

(56) References cited:
- EP-A1- 2 741 328
- EP-A2- 3 045 963
- CN-A- 102 760 820
- CN-A- 104 465 958
- CN-A- 105 762 144
- CN-A- 105 870 303

## Description

### FIELD OF THE INVENTION

The invention relates to a field of LED packaging technology, particularly to a COB light source.

In particular the invention relates to a chip on board (COB) light source, comprising: a substrate, at least one LED chip, a surrounding dam, and a fluorescent glue, wherein the surrounding dam which has a closed annular body is arranged on the substrate, the at least one LED chip is configured on the substrate and inside the surrounding dam, and the inside of the surrounding dam is filled with the fluorescent glue, and wherein the at least one LED chip is a high voltage blue LED chip.

### BACKGROUND OF THE INVENTION

CN 104465958 A discloses a COB light source of the generic type as defined above.

LED, known as a new generation light source, has a plurality of advantages as follows: energy-saving, eco-friendly, safe, long lifetime, low power consumption, low heat radiation, hight brightness, water-proof, mini-sized, shock-proof, adjustable light, contracted beam, and easy maintainability, so it is widely used in multiple fields such as indication, display, decoration, back light, general illumination and so on.

COB light source packaging, also known as chip on board packaging, is one of surface-mount techniques of bare dies, wherein LED chips are mounted on a printed circuit board and the electrical connection between chips and the substrate is done by wire-bonding technology, and a resin coating is applied thereon to ensure reliability. With the widespread use of the COB lighting products, people pay more attention to products performance and quality of light colours. Most of the COB products in markets have low colour rendering index (Ra is usually below 70), and poor capacity of revealing colours of objects, so the fidelity of colours displayed is subjected to distortion, which is not adapted to visual preference of human eyes; besides, the power sources of general COB products are DC low voltage and COB products with different power need power resources in different norms, so power sources in various standards are required and the cost thereof increases, meanwhile, the conversion efficiency of the low voltage power source is lower than that of the high voltage power source, so it is necessary to provide a novel COB light source to solve the preceding problems.

CN 105762144 A provides a full-spectrum high-color-rendering LED white light emitting device to solve the problems of spectrum incompletion of white light produced by LED excited fluorescent powder including high components of blue light peak values, poor color reducibility and the like. The full-spectrum high-color-rendering LED white light emitting device comprises a device support and device pins, wherein at least one group of light emitting units electrically connected with the device pins is arranged on the device support, each light emitting unit comprises two or more blue light LED chips of different wavelengths, LED chips are fixed to the device support through insulation paste or are fixed to the device pins through elargol, and a cavity where the LED chips are fixed is filled with a mixture of fluorescent powder and silica gel.

CN 104465958 A provides a high-voltage white light LED, which comprises a substrate, a LED chip, a transparent support, and a fluorescent glue, wherein the transparent support is arranged on the substrate, the LED chip is configured on the substrate and inside the transparent support, and the fluorescent glue covers the LED chip. The LED chip is a high voltage blue LED chip.

CN 102760820 A provides a white-light LED light source, which comprises a yellowish green fluorescent powder having an emitting wavelength of 526-575 nm, and a red fluorescent powder having an emitting wavelength of 600-660 nm, wherein the yellowish green fluorescent powder and the red fluorescent powder are dispersed in a silica gel, and wherein the mass ratio of the yellowish green fluorescent powder to the red fluorescent powder ranges from 60:40 to 95:5. The present invention provides a COB light source which has a high colour rendering index and high power source conversion efficiency and is capable of revealing real colours of objects better, which is beneficial to human eyes.

### SUMMARY OF THE INVENTION

The technical problem to be solved by the present invention is providing a COB light source which has a high colour rendering index, high power source conversion efficiency, and is capable of revealing real colour of objects better, which is beneficial to human eyes.

So as to solve the mentioned problem, the present invention provides a chip on board (COB) light source, comprising: a substrate, at least one LED chip, a surrounding dam, and a fluorescent glue, wherein the surrounding dam which has a closed annular body is arranged on the substrate, the at least one LED chip is configured on the substrate and inside the surrounding dam, and the inside of the surrounding dam is filled with the fluorescent glue, wherein the at least one LED chip is a high voltage blue LED chip, wherein the fluorescent glue consists of a silica gel, a yellow-green phosphor, and a red phosphor, and wherein the yellow-green phosphor has an emitting peak wavelength of 530nm to 540nm and makes up 10% of the silica gel in mass while the red phosphor has an emitting peak wavelength of 620nm to 640nm and makes up 10% of the silica gel in mass.

Preferably, the substrate is a metal substrate whose obverse is configured with a die bonding zone, and a high reflective coating with a reflectivity more than 98% is configured on a surface of the die bonding zone.

Preferably, the high reflective coating is a mirror aluminum coating. Preferably, the high voltage blue LED chip is manufactured by dividing a chip in large size into multiple luminescent units, isolating the luminescent units by isolation trenches, and connecting the luminescent units in series by electrode bridges.

Preferably, the width of the isolation trenches is 19µm to 21 µm. Preferably, the width of the isolation trenches is 20 µm.

Preferably, the range of dominant wavelength of the high voltage blue LED chip is 450nm to 460nm, the voltage thereof is 9V to 9.3V, the emitting peak wavelength thereof is 455nm to 457.5nm, and the power thereof is 3W to 5W, and at least 23 high voltage blue LED chips are connected in series.

Preferably, the surrounding dam has a closed annular body configured on the obverse of the substrate and surrounding the die bonding zone, and the surrounding dam is made of white dam glue and has a diameter of 9mm to 13mm and a body width of 0.9mm to 1.3mm.

Compared to the prior art, the present invention advances in the following aspects:
The COB light source according to the present invention utilizes a high voltage blue LED chip to excite the yellow-green phosphor and red phosphor and its colour rendering index Ra is more than 80 and colour gamut is higher so that the problem of low spectral colour gamut and low colour rendering index of the COB light source can be overcome, whereby it is able to reveal real colours of objects better and benefits human eyes.

In the COB light source according to the present invention, a high reflective coating with a reflectivity more than 98% is configured on a surface of the die bonding zone. In the present embodiment, the high reflective coating is a mirror aluminum coating for raising the reflectivity and luminous efficiency of the COB light source.

In the COB light source according to the present invention, the width of the isolation trenches between the high voltage blue LED chips is 19-21µm, so as to optimize the electrical and optical performance of the LED chips. In the COB light source according to the present invention, the silica gel is heat-resisting material which can bear temperature higher than 250°C. The COB light source generates more heat than the LED light source, the heat-resisting silica gel can prevent the fluorescent glue from ageing due to high temperature, and thereby reliability of the COB light source is enhanced.

The voltage of the COB light source according to the present invention is close to 220V, and the conversion efficiency of the power source becomes higher, on the other hand, the norms of power sources are unified and the cost thereof decreases.

### BRIEF DECRIPTION OF THE DRAWINGS

Figure 1 is a structural diagram of the COB light source according to the present invention.
Figure 2 shows a spectrum analysis curve diagram of a traditional COB light source.
Figure 3 shows a spectrum analysis curve diagram of the COB light source according to the present invention.

### DETAILED DESCRIPTION OF ILLUSTRATED EMBODIMENTS

So as to facilitate the skilled person in the art in understanding the technical solution of the present invention, further detailed description of the present invention is given hereinafter with reference to drawings and preferred embodiments.

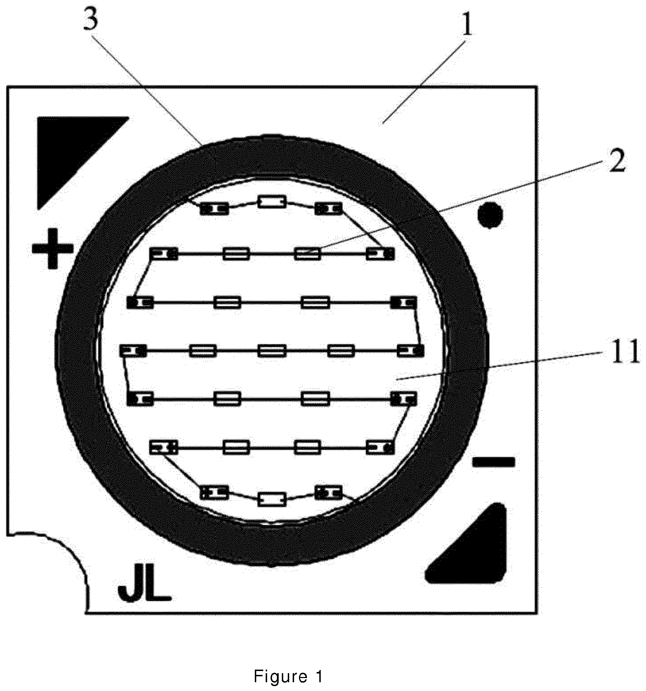

As shown in figure 1, a chip on board (COB) light source comprises a substrate 1, at least one LED chip 2, a surrounding dam 3, and fluorescent glue (not shown), wherein the surrounding dam 3 which has a closed annular body is arranged on the substrate 1, the at least one LED chip 2 which is a high voltage blue LED chip is configured on the substrate 1 and inside the surrounding dam 3, and the inside of the surrounding dam 3 is filled with the fluorescent glue consisting of a silica gel, a yellow-green phosphor, and a red phosphor.

The substrate 1 is a metal substrate whose obverse is configured with a die bonding zone 11, further preferably, a high reflective coating with a reflectivity more than 98% is configured on a surface of the die bonding zone. In the present embodiment, the high reflective coating is a mirror aluminum coating for raising the reflectivity and luminous efficiency of the COB light source.

The at least one LED chip 2 is a high voltage blue LED chip. The high voltage blue LED chip is manufactured by dividing a chip in large size into multiple luminescent units, isolating the luminescent units by isolation trenches, and connecting the luminescent units in series by electrode bridges, in which way, a low current, high voltage and high power at least one LED chip is obtained.

So as to optimize electrical and optical performance of the LED chips, the width of the isolation trenches between the LED chips is configured to be 19µm to 21 µm, particularly, the width of the isolation trenches between the LED chips is 19µm, 20µm, or 21µm. If the width of the isolation trenches is less than 19µm, the poor metal evaporation quality will cause high resistivity and then high resistance of the electrode bridges, so the voltage of the chips is high; if the width of the isolation trenches is 19µm to 21 µm, the metal evaporation quality will become better and the resistivity will go lower, which will cause the resistance of the electrode bridges and then the voltage of the chips to decrease; if the width of the isolation trenches is more than 21 µm, the resistance of the electrode bridges will start to rise and then the voltage of the chips rises accordingly. The trend that the output light power rises firstly and falls later results from the difference of optical coupling capacity between neighbouring luminescent units.

Further preferably, the width of the isolation trenches between the LED chips is configured as 20µm, where the LED chips have the optimum electrical and optical performance.

The at least one LED chip 2 provided in the present invention is a high voltage blue LED chip whose dominant wavelength range is 450nm to 460nm, voltage is 9V to 9.3V, emitting peak wavelength is 455nm to 457.5nm, and power is 3W to 5W. In order to make the total voltage of COB light sources go close to the voltage of mains electricity, i.e. more than 200V, at least 23 high voltage blue LED chips are connected in series, and particularly 27 LED chips connected in series as a whole is connected with another LED chip in parallel in the embodiment, so that the voltage of the COB light source is close to 220V and the conversion efficiency of the power source becomes higher, on the other hand, the norms of power sources are unified and the cost thereof decreases.

The surrounding dam 3 has a closed annular body configured on the obverse of the substrate and surrounding the die bonding zone 11. The surrounding dam 3 is made of white dam glue and has a diameter of 9mm to 13mm and a body width of 0.9mm to 1.3mm. Particularly, the body width of the dam is 0.9mm, 1.0mm, 1.1mm, or 1.3 mm. The present invention uses white dam glue to form the surrounding dam 3 in order to enhance the reflectivity of the COB light source.The width of the dam body is configured as 0.9mm to 1.3mm; if the width thereof is less than 0.9mm, the surrounding dam will be easily to fall off the substrate due to poor adhesion therebetween, and the reliability of the COB light source will be inferior; if the width thereof is more than 1.3 mm, too much area on the substrate will be seized by the surrounding dam, which goes against compactness of the COB light source.

The fluorescent glue consists of silica gel, yellow-green phosphor, and red phosphor. The silica gel in the present invention is heat-resisting material which can bear temperature higher than 250°C. Because the COB light source generates more heat than the LED light source, the heat-resisting silica gel can prevent the fluorescent glue from ageing due to high temperature, and thereby reliability of the COB light source is enhanced. The yellow-green phosphor has an emitting peak wavelength of 530nm to 540nm and makes up 10% of the silica gel in mass. The red phosphor has an emitting peak wavelength of 620nm to 640nm and makes up 10% of the silica gel in mass.

Optical and electric parameters of the COB light source are tested by using a 3900T test machine and the results thereof are listed in the following chart 1,
Optical and electric parameters of the COB light source

**Chart 1**

| Colour temperature (K) | CIE-X | CIE-Y | Luminous flux (Im) | Luminous efficacy (Im/w) | Voltage VF (V) | Current (mA) | Colour rendering index |
|---|---|---|---|---|---|---|---|
| 3028 | 0.4382 | 0.4094 | 464.983 | 131 | 235 | 15 | 81 |

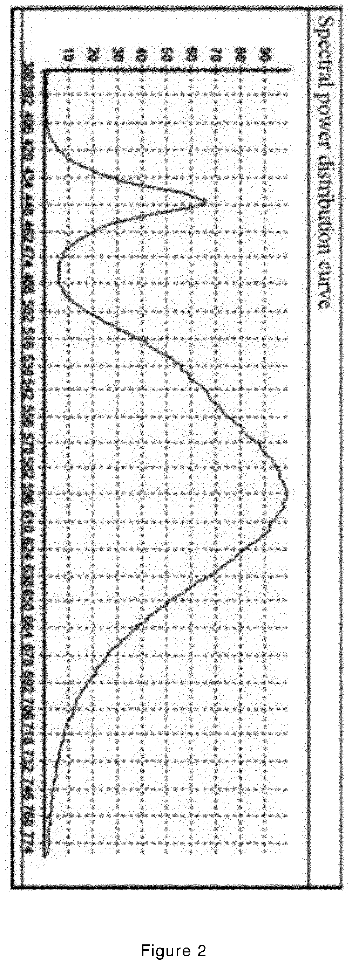

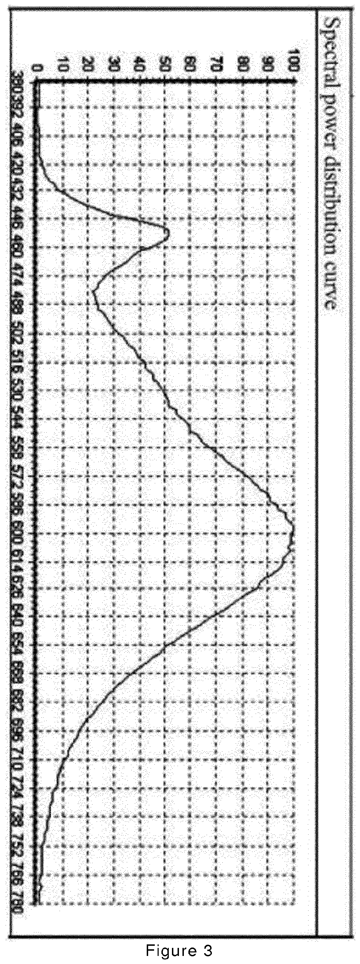

As shown in figures 2 and 3, figure 2 shows a spectrum analysis curve diagram of a traditional COB light source and figure 3 shows a spectrum analysis curve diagram of the COB light source according to the present invention. It can be seen from chart 1, and figures 2 and 3 that the COB light source according to the present invention utilizes a high voltage blue LED chip to excite the phosphor having such ingredients, proportion, and wavelengths, that its colour rendering index Ra is more than 80 and its colour gamut goes higher, so the problem of low spectral colour gamut and low colour rendering index of COB light source can be overcome, whereby it is able to reveal real colours of objects better and benefits human eyes. Compared to the prior art, the present invention advances in the following aspects:
The COB light source according to the present invention utilizes a high voltage blue LED chip to excite the yellow-green phosphor and red phosphor and its colour rendering index Ra is more than 80 so that the problem of low spectral colour gamut and low colour rendering index of the COB light source can be overcome, whereby it is able to reveal real colour of objects better and benefits human eyes.

In the COB light source according to the present invention, a high reflective coating with a reflectivity more than 98% is configured on a surface of the die bonding zone. In the present embodiment, the high reflective coating is a mirror aluminum coating for raising the reflectivity and luminous efficiency of the COB light source.

In the COB light source according to the present invention, the width of the isolation trenches between the high voltage blue LED chips is 19µm to 21µm, so as to optimize the electrical and optical performance of the LED chips. In the COB light source according to the present invention, the silica gel is heat-resisting material which can bear temperature higher than 250°C. Because the COB light source generates more heat than the LED light source, the heat-resisting silica gel can prevent the fluorescent glue from ageing due to high temperature, and thereby reliability of the COB light source is enhanced.

The voltage of the COB light source according to the present invention is close to 220V, and the conversion efficiency of the power source becomes higher, on the other hand, the norms of power sources are unified and the cost thereof decreases.

The foregoing descriptions are preferred embodiments only. It should be noted that various substitutions and modifications have been suggested in the foregoing description, and others will occur to those of ordinary skill in the art. Therefore, all such substitutions and modifications are intended to be embraced within the scope of the invention as defined by the appended claims.

## Claims

1. A chip on board (COB) light source, comprising:
a substrate (1), at least one LED chip (2), a surrounding dam (3), and a fluorescent glue, wherein the surrounding dam (3) which has a closed annular body is arranged on the substrate (1), the at least one LED chip (2) is configured on the substrate (1) and inside the surrounding dam (3), and the inside of the surrounding dam (3) is filled with the fluorescent glue, and wherein the at least one LED chip (2) is a high voltage blue LED chip,
**characterised in that** the fluorescent glue consists of a silica gel, a yellow-green phosphor, and a red phosphor, and that the yellow-green phosphor has an emitting peak wavelength of 530nm to 540nm and makes up 10% of the silica gel in mass while the red phosphor has an emitting peak wavelength of 620nm to 640nm and makes up 10% of the silica gel in mass.

2. The COB light source according to claim 1, wherein the substrate (1) is a metal substrate whose obverse is configured with a die bonding zone (11), and wherein a high reflective coating with a reflectivity more than 98% is configured on a surface of the die bonding zone (11).

3. The COB light source according to claim 2, wherein the high reflective coating is a mirror aluminum coating.

4. The COB light source according to claim 1, wherein the range of dominant wavelength of the high voltage blue LED chip is 450nm to 460nm, the voltage thereof is 9V to 9.3V, the emitting peak wavelength thereof is 455nm to 457.5nm, and the power thereof is 3W to 5W, and wherein at least 23 high voltage blue LED chips are connected in series.

5. The COB light source according to claim 2, wherein the surrounding dam (3) has a closed annular body configured on the obverse of the substrate (1) and surrounding the die bonding zone (11), and wherein the surrounding dam (3) is made of white dam glue and has a diameter of 9mm to 13mm and a body width of 0.9mm to 1.3mm.

## Patentansprüche

1. Chip-on-Board-(COB-)Lichtquelle, umfassend:
ein Substrat (1), mindestens einen LED-Chip (2), eine umgebende Schutzwand (3) und einen fluoreszierenden Klebstoff, wobei die umgebende Schutzwand (3), die einen geschlossenen Ringkörper aufweist, auf dem Substrat (1) angeordnet ist, der mindestens eine LED-Chip (2) auf dem Substrat (1) und innerhalb der umgebenden Schutzwand (3) konfiguriert ist und das Innere der umgebenden Schutzwand (3) mit dem fluoreszierenden Klebstoff gefüllt ist, und wobei der mindestens eine LED-Chip (2) ein blauer Hochspannungs-LED-Chip ist,
**dadurch gekennzeichnet, dass** der fluoreszierende Klebstoff aus einem Kieselgel, einem gelb-grünen Leuchtstoff und einem roten Leuchtstoff besteht, dass der gelbgrüne Leuchtstoff eine emittierende Peak-Wellenlänge von 530 nm bis 540 nm aufweist und 10 % der Masse des Kieselgels ausmacht, während der rote Leuchtstoff eine emittierende Peak-Wellenlänge von 620 nm bis 640nm aufweist und 10 % der Masse des Kieselgels ausmacht.

2. COB-Lichtquelle nach Anspruch 1, wobei das Substrat (1) ein Metallsubstrat ist, dessen Vorderseite mit einer Die-Bonding-Zone (11) konfiguriert ist, und wobei auf einer Oberfläche der Die-Bonding-Zone (11) eine hochreflektierende Beschichtung mit einem Reflexionsvermögen von mehr als 98 % konfiguriert ist.

3. COB-Lichtquelle nach Anspruch 2, wobei die hochreflektierende Beschichtung eine Aluminium-Verspiegelungsbeschichtung ist.

4. COB-Lichtquelle nach Anspruch 1, wobei der Bereich der dominanten Wellenlänge des blauen Hochspannungs-LED-Chips 450 nm bis 460 nm beträgt, seine Spannung 9 V bis 9,3 V beträgt, seine emittierende Peak-Wellenlänge 455 nm bis 457,5 nm beträgt, und seine Leistung 3 W bis 5 W beträgt, und wobei mindestens 23 blaue Hochspannungs-LED-Chips in Reihe geschaltet sind.

5. COB-Lichtquelle nach Anspruch 2, wobei die umgebende Schutzwand (3) einen geschlossenen Ringkörper aufweist, der auf der Vorderseite des Substrats (1) konfiguriert ist und die Die-Bonding-Zone (11) umgibt, und wobei die umgebende Schutzwand (3) aus weißem Schutzwand-Kleber hergestellt ist und einen Durchmesser von 9 mm bis 13 mm und eine Körperbreite von 0,9 mm bis 1,3 mm aufweist.

## Revendications

1. Source de lumière puce sur carte (COB), comprenant :
un substrat (1), au moins une puce DEL (2), un barrage entourant (3), et une colle fluorescente, dans laquelle le barrage entourant (3) qui a un corps annulaire fermé est disposé sur le substrat (1), l'au moins une puce DEL (2) est configurée sur le substrat (1) et à l'intérieur du barrage entourant (3), et l'intérieur du barrage entourant (3) est rempli avec la colle fluorescente, et dans laquelle l'au moins une puce DEL (2) est une puce DEL bleue haute tension,
**caractérisée en ce que** la colle fluorescente consiste en un gel de silice, un phosphore jaune-vert, et un phosphore rouge, et **en ce que** le phosphore jaune-vert a une longueur d'onde de pic d'émission de 530 nm à 540 nm et représente 10% en masse du gel de silice alors que le phosphore rouge a une longueur d'onde de pic d'émission de 620 nm à 640 nm et représente 10% en masse du gel de silice.

2. Source de lumière COB selon la revendication 1, dans laquelle le substrat (1) est un substrat métallique dont le recto est configuré avec une zone de connexion de puce (11), et dans laquelle un revêtement hautement réfléchissant avec une réflectivité de plus de 98% est configuré sur une surface de la zone de connexion de puce (11).

3. Source de lumière COB selon la revendication 2, dans laquelle le revêtement hautement réfléchissant est un revêtement d'aluminium réflecteur.

4. Source de lumière COB selon la revendication 1, dans laquelle la plage de longueur d'onde dominante de la puce DEL bleue haute tension est de 450 nm à 460 nm, la tension de celle-ci est de 9V à 9,3V, la longueur d'onde de pic d'émission de celle-ci est de 455 nm à 457,5 nm, et la puissance de celle-ci est de 3W à 5W, et dans laquelle au moins 23 puces DEL bleues haute tension sont connectées en série.

5. Source de lumière COB selon la revendication 2, dans laquelle le barrage entourant (3) a un corps annulaire fermé configuré sur le recto du substrat (1) et entourant la zone de connexion de puce (11), et dans laquelle le barrage entourant (3) est constitué de colle de barrage blanche et a un diamètre de 9 mm à 13 mm et une largeur de corps de 0,9 mm à 1,3 mm.
